(19)

**Europäisches Patentamt**
**European Patent Office**
**Office européen des brevets**

(11)  **EP 4 296 631 B1**

(12)  **EUROPEAN PATENT SPECIFICATION**

(45) Date of publication and mention
of the grant of the patent:
**17.06.2026  Bulletin 2026/25**

(21) Application number: **23209438.3**

(22) Date of filing: **20.12.2018**

(51) International Patent Classification (IPC):
*G01F 1/667* (2022.01)    *G01R 19/00* (2006.01)

(52) Cooperative Patent Classification (CPC):
**G01F 1/667; G01R 19/0023**

(54) **ULTRASONIC FLOW METER WITH SWITCHABLE TRANSDUCERS**

ULTRASCHALLDURCHFLUSSMESSER MIT SCHALTBAREN WANDLERN

DÉBITMÈTRE À ULTRASONS AVEC TRANSDUCTEURS COMMUTABLES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**27.12.2023  Bulletin 2023/52**

(62) Document number(s) of the earlier application(s) in
accordance with Art. 76 EPC:
**18833836.2 / 3 899 441**

(73) Proprietor: **Apator Miitors ApS
8210 Aarhus V (DK)**

(72) Inventors:
- **DRACHMANN, Jens
  8210 Århus V (DK)**
- **HELSTRUP, Kresten
  8210 Århus V (DK)**

(74) Representative: **Patentgruppen A/S
Aaboulevarden 31, 4th Floor
8000 Aarhus C (DK)**

(56) References cited:
**EP-A1- 2 343 515      US-A1- 2003 200 817
US-A1- 2007 006 665    US-A1- 2016 282 170
US-A1- 2018 198 414**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### Field of the invention

The present invention relates to sensing an ultrasound signal received by an ultrasonic transducer connected to a receiving amplifier of an ultrasonic flow meter.

### Background of the invention

Many ultrasonic flow meters for measuring the flow rate of a fluid are based on a principle method where a signal is generated by a signal generator circuit including an ultrasonic transducer, transmitted through the fluid and measured by a receiver circuit including another ultrasonic transducer, then reversing the process to make a similar measurement through the fluid in the opposite direction, and finally calculating a flow rate based on a difference between the measured signals.

Because this principle method is based on the difference between signals that are equal except for the direction they are transmitted through the fluid, a significant consideration when trying to improve stability and accuracy of flow rate measurements in practical circuits, is the degree of compliance with the reciprocity theorem for linear passive circuits. Generally, better compliance with the reciprocity theorem, and thereby improved measurement, is achieved when it is attempted to get the difference between the impedance seen from a transducer when it is acting as a transmitter and a receiver, respectively, to be as small as possible.

Numerous different implementations of the above principle method exist and have provided different solutions to reducing the impedance difference between a transducer's sending and receiving role as much as possible.

Some implementations have separate generator and receiver circuits, and often use a switching circuit to be able to switch the transducers between the sending and receiving circuits when the measurement direction should be changed. Such an implementation is for example disclosed in WO2011/134470A2 and shown in simplified form in Fig. 1 of the present application. The signal generator SG generates a waveform which is connected to one of the transducers TR2 through a switching unit SU and rendered as ultrasound into the fluid FL. The ultrasound is received by the other transducer TR1 and connected to the receiver circuit RC through the switching unit SU. For the opposite transmission, the switching unit SU changes both switches, to swap the sending and receiving transducer. The impedance into the circuit seen from a sending transducer, in this example TR2, is denoted Zt and corresponds to the output impedance of the signal generator SG. The impedance seen into the circuit from a receiving transducer, in this example TR1, is denoted Zr and corresponds to the input impedance of the receiver circuit RC. By designing the signal generator SG circuit to have a very low output impedance Zt, and the receiving circuit to have a very low input impedance Zr, the difference between the two impedances Zt and Zr will become increasingly insignificant, and thereby make the implementation increasingly compliant with the reciprocity theorem.

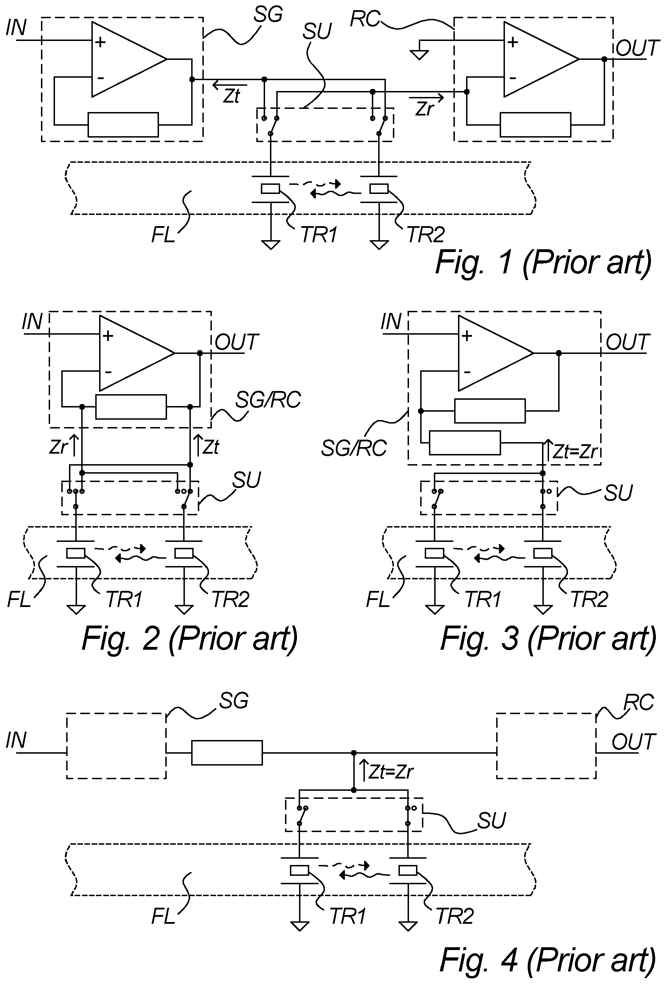

Other implementations have a single common transceiver circuit connected to both transducers through a switching circuit used to ensure that that only one of the transducers is connected when sending, and only the other transducer is connected when receiving. Such an implementation is for example also disclosed in WO2011/134470A2 and shown in simplified form in Fig. 2 of the present application. The principle is similar to that of Fig. 1, but a single op-amp is used in common for both the signal generator and the receiver circuit as a combined transceiver SG/RC. The generated waveform is output from the op-amp's output, and the received signal is received at the op-amp's inverting input. To avoid the transmission and receiving disturbing each other, the receiving transducer, e.g. TR1, is disconnected by means of the switching unit SU when a signal is transmitted, and the transmitting transducer, e.g. TR2, is disconnected by means of the switching unit SU when a signal is expected to be received. Thus, there can be no timewise overlap of transmission and reception, and twice as many switching operations are required compared to the Fig. 1 implementation. The impedances experienced from the transducers are the same as in the Fig. 1 implementation, whereby very low output impedance Zt and very low input impedance Zr of the combined transceiver SG/RC makes the difference between the two impedances Zt and Zr to become increasingly insignificant, and thereby make the implementation increasingly compliant with the reciprocity theorem.

However, for both the Fig. 1 and Fig. 2 implementations, a disadvantage is that, while the two impedances Zt and Zr may be quite close and small, they will not be equal, and thereby not allow the implementations to comply fully with the reciprocity theorem.

Another example of a combined transceiver implementation is disclosed in WO03/036240A1 and shown in simplified form in Fig. 3 of the present application. Like in the previous implementation example, a combined transceiver SG/RC swaps, by means of a switching unit SU, between transmitting a waveform to one of the transducers, in this example TR2, and receiving the waveform from the other transducer, in this example TR1. However, in this implementation, both the sending and receiving transducer is connected to the op-amp's inverting input through a resistor. This means, that the impedance into the circuit seen from a sending transducer, in this example TR2, denoted Zt, is equal to the impedance seen into the circuit from a receiving transducer, in this example TR1, denoted Zr. Thereby the Fig. 3 implementation is theoretically highly compliant with the reciprocity theorem.

An example of another implementation with separate signal generator and receiver circuits is disclosed in EP0846936A1 and shown in simplified form in Fig. 4 of the present application. The output of the signal generator SG is connected through a resistor to the input of the receiver circuit RC. Both the signal generator and the receiver circuit are designed to generate square wave signals from their input, whereby the receiver circuit will recreate a square wave signal from the received transducer signal. A switching unit SU is provided to select which transducer, in this example TR2, is transmitting a waveform from the signal generator SG. When the transmission is finished, the switching unit SU will select the other transducer, in this example TR1, as receiving transducer and couple it to the receiving circuit RC. As both the sending and receiving transducer in this implementation is connected to the same node in the circuit, the impedance into the circuit seen from a sending transducer, in this example TR2, denoted Zt, is equal to the impedance seen into the circuit from a receiving transducer, in this example TR1, denoted Zr. Thereby the Fig. 4 implementation is theoretically highly compliant with the reciprocity theorem.

However, in both the Figs. 3 - 4 implementations, a resistor or other impedance is provided between the signal generator SG and the transmitting transducer to establish a required potential but thereby also increasing the loss and limiting the electrical signal that can be supplied to the transducers, and causing a relatively high output impedance of the signal generator SG, which also appear as an input impedance for the receiver circuit RC.

A further disadvantage of the prior art is, that because no timewise overlap between transmission and reception is possible in for example the Figs. 2 - 4 implementations, they require the signal propagation time through the fluid to be sufficiently long for the combined circuit to finish transmission of the last part of the signal before the first part of the signal appears at the receiving transducer. This in practice means that the distance between the two transducers have to be significantly larger than required in for example the Fig. 1 implementation, which makes the Figs. 2 - 4 implementations only relevant for large flow meters.

Summing up, the attempts of the prior art to provide an ultrasonic flow meter that complies with the reciprocity theorem to increase stability and accuracy, suffer from various deficits such as for example not being able to simultaneously achieve very low impedance, not being usable in small flow meters, and/or not complying with the reciprocity theorem to a desirable extend.

US2018/0198414A1 relates to a pulsed power amplifier, such as used in radar, sonar and electronic counter measure applications, wherein the amplifier current is measured and used for automatic control of gate-bias level during transmission of pulses.

## Summary of the invention

The inventors have identified the above-mentioned problems and challenges related to complying with the reciprocity theorem in ultrasonic flow meters, and subsequently made the below-described invention providing an alternative solution which in various embodiments may increase the stability and accuracy, may be implemented in small flow meters, and/or may offer improved compliance with the reciprocity theorem at least with respect to the impedance seen from the transducers.

The invention relates to an ultrasonic flow meter according to the claims. The inventors have unexpectedly conceived this novel and advantageous invention for sensing an ultrasound signal received by an ultrasonic transducer connected to a receiving amplifier of an ultrasonic flow meter. This embodiment of a measuring amplifier for ultrasonic signals is highly advantageous because it has extremely little and insignificant impact on the impedance seen from the transducer, and thereby does not decrease the flow meter's compliance with the reciprocity theorem. All the various discussions, considerations and embodiments described below also applies to this flow meter with means for measuring power supply current, and the embodiments thereof.

In an embodiment the two ultrasonic transducers are coupled through a switching unit to a signal generator and a receiver circuit in such a way that the ultrasonic transducers by means of a control circuit controlling the switching unit each can be set to one of at least a transmitter mode and a receiver mode at a time, where the transmitter mode involves the respective ultrasonic transducer being coupled to the signal generator and the receiver mode involves the respective ultrasonic transducer being coupled to the receiver circuit; wherein a respective one of the ultrasonic transducers is set to the receiver mode, it is coupled to the receiver circuit so that a first receiver impedance between the respective ultrasonic transducer and an output of a receiving operational amplifier of the receiver circuit is less than or equal to a second receiver impedance between the respective ultrasonic transducer and an inverting input of said receiving operational amplifier of the receiver circuit.

By coupling a receiving transducer to an output of one of the op-amps of the receiver circuit, i.e. so-to-say reversing the op-amp, the perceived impedance when in receiver mode and looking into the receiver circuit is thereby substantially equal to the perceived impedance when in transmitter mode and looking into the signal generator where it may as usual be coupled to the output of the transmitter op-amp.

In other words, the novel arrangement of the receiver circuit of the present embodiment facilitates both substantial equal and relatively low impedance of both transmission and reception, thereby improving compliance with the reciprocity theorem which facilitates more stable and accurate measurements. Improved accuracy is achieved because the same impedances are perceived for transmissions in both directions, i.e. when the transducers switch modes between transmitting and receiving. Improved stability is achieved because temperature changes and other environmental fluctuations or degradation of transducers over time have the same impact on both the transmitting and the receiving circuit, again regardless of which transducer is currently in which mode. This is a significant improvement over the prior art which, as described above, did only achieve equal impedances with relatively high impedances for transmission and reception.

Further, the substantially equal transmitter and receiver impedances of the present embodiment can be obtained even with separated signal generator and receiver circuit, thereby enabling simultaneous transmission and receiving, which again enables flow meters having a shorter distance between the two transducers, i.e. smaller flow meters. This is a significant improvement over the prior art which, as described above, only disclosed equal impedances for systems where the same circuit was used for both transmission and reception, thereby requiring a large distance between the transducers to avoid simultaneous transmission and reception.

The signal generator is arranged to generate a transmission signal suitable for transmission from an ultrasonic transducer through a fluid for receipt by another ultrasonic transducer. Various signals suitable for this purpose and signal generators to create them are known by the skilled person in the art of ultrasonic flow meters, see for example again WO2011/134470A2 mentioned above. The transmission signal thus generated and transmitted through the fluid is in practice never an ideal single frequency signal, whether or not such is desired, and the transmission signal may therefore be said to have a frequency spectrum of a certain bandwidth. In the present application, the term signal frequency is understood as the centre frequency of this frequency spectrum of the transmission signal.

Impedance is generally frequency-dependent, and when dimensioning or evaluating impedances it should therefore be considered what the relevant frequency is for the particular implementation. Where the present application describes comparison of impedances or uses a relationship between impedances as a definition, like the above definition that the first receiver impedance is less than or equal to the second receiver impedance, it is understood herein as comparing or relating the magnitudes of the respective impedances at the signal frequency, i.e. at the centre frequency of the transmission signal spectrum.

The above-mentioned configuration of the transducers relative to the receiving operational amplifier so that the first receiver impedance is less than or equal to the second receiver impedance, i.e. $ZR1 \leq ZR2$, may preferably be achieved by connecting the transducer, by means of the switching unit and possibly via one or more series impedances such as the power regulating impedance described below, quite unconventionally to the output of the receiving operational amplifier, and from that node establish a feedback to the inverting input with or without a feedback impedance. Thereby the second receiver impedance from the transducer to the inverting input will be larger than the first receiver impedance from the transducer to the output by an amount corresponding to the magnitude of the feedback impedance, if any, i.e. $ZR2 \approx ZR1 + Zf$, where $Zf \geq 0$. Again, when discussing impedance relationships herein, is considered a simplified perspective where only the magnitude of the impedance at the signal frequency is considered.

In an embodiment the coupling of a respective one of the ultrasonic transducers to the signal generator when the respective ultrasonic transducer is set to the transmitter mode, is arranged so that a first transmitter impedance between the respective ultrasonic transducer and an output of a transmitting operational amplifier of the signal generator is less than or equal to a second transmitter impedance between the respective ultrasonic transducer and an inverting input of said transmitting operational amplifier of the signal generator.

By coupling the transmitting transducer to the output of an op-amp of the signal generator as usual, and with the above-described novel coupling of the receiving transducer to the output of an op-amp of the receiving circuit, both the transmitting transducer and the receiving transducer are coupled to outputs of op-amps, thereby enabling equal impedance in both situations. Preferably the auxiliary impedances such as a feedback network of the operational amplifier, current limiting resistors, decoupling capacitors, filters, etc., should also be equal in both the signal generator and the receiving circuit to achieve equal impedance for both transmission and reception.

The discussion about impedance and relationships above applies analogously to the signal generator, whereby the signal generator is configured to achieve that $ZT1 \leq ZT2$, and $ZT2 \approx ZT1 + Zf$, where $Zf \geq 0$.

In an embodiment the first receiver impedance is substantially equal to the first transmitter impedance.

To achieve the highest compliance with the reciprocity theorem, the ultrasonic flow meter is designed with the receiver impedance being substantially equal to the transmitter impedances, i.e. $ZR1 \approx ZT1$ and $ZR2 \approx ZT2$, which also means that the feedback impedance of both the transmitting operational amplifier and the receiving operational amplifier should be substantially equal.

In an embodiment the receiver circuit comprises a measuring amplifier.

The measuring amplifier is arranged to establish a representation of a received ultrasound signal from the novel receiver circuit. Various embodiments of measuring amplifiers are feasible, some of which are described below. The representation of a received ultrasound signal may be used in the flow meter to calculate the current flow of fluid and thereby the accumulated volume, as know by the person skilled in the art of ultrasonic flow meters.

In an embodiment the measuring amplifier comprises a measuring operational amplifier different from the receiving operational amplifier.

As the received ultrasound signal may only cause a weak influence on the novel, reversed operational amplifier configuration of the receiver circuit of the present embodiment, the measuring amplifier is preferably arranged to amplify the signal. Instead of a measuring operational amplifier, other amplification technologies may also be employed in some measuring amplifier embodiments for use in the present invention.

In an embodiment the measuring amplifier is arranged to provide a measured ultrasonic signal at a measurement output of the measuring amplifier, preferably at the output of the measuring operational amplifier.

In an embodiment the measuring amplifier is arranged to measure a representation of an AC current drawn through at least one power supply terminal of the receiving operational amplifier.

The inventors have unexpectedly conceived this novel and advantageous invention for sensing an ultrasound signal received by an ultrasonic transducer connected to a reversed operational amplifier, i.e. by less or equal impedance to an output of the operational amplifier than to its inverting input as described above. This embodiment of a measuring amplifier is highly advantageous because it has extremely little and insignificant impact on the impedance seen from the transducer, and thereby does not decrease the flow meter's compliance with the reciprocity theorem.

In an embodiment the measurement amplifier is coupled to said power supply terminal through a measurement impedance, preferably at least one capacitor.

Thereby is achieved a configuration where the major part of the power consumed by the receiving operational amplifier, typically primarily DC current, may be supplied directly from the power supply rails, and a lesser part, preferably primarily the AC part hence the preferred implementation by a capacitor, runs through the measuring amplifier.

In an embodiment the at least one power supply terminal of the receiving operational amplifier is coupled to a power supply through a sense impedance.

The sense impedance may ideally be an AC rejecting impedance such as a coil or ferrite core, to force the AC part of the supply current to run through the measuring amplifier. However, for practical reasons, it is preferred to apply a resistor as sense impedance, which should therefore be dimensioned large enough to force a sufficient part of the AC current through the measurement amplifier, and small enough to not unnecessarily dissipate too much power.

In an embodiment said sense impedance is larger than 10% of said measurement impedance, preferably equal to or larger than said measurement impedance.

In an embodiment said sense impedance is a resistor, preferably less than 1 kOhm.

As discussed above, the sense impedance should preferably have a certain dimension compared to the measurement impedance, such as above 10%, or preferably equal to or larger, as long as it does not get too large. Again, when discussing impedance relationships herein, is considered a simplified perspective where only the magnitude of the impedance at the signal frequency is considered.

In an embodiment the measuring amplifier is implemented substantially as a transimpedance amplifier with a sense input connected to said power supply terminal.

In an embodiment the measuring amplifier is arranged to measure a representation of a voltage at the respective one of the ultrasonic transducers set to receiver mode.

Thereby a representation of a received ultrasound signal may be measured.

In an embodiment a respective one of the ultrasonic transducers set to receiver mode is coupled to the non-inverting input of a measuring operational amplifier of the measuring amplifier, and preferably a power regulating impedance is provided between said respective one of the ultrasonic transducers and said output of said receiving operational amplifier.

To achieve symmetry between the signal generator and the receiving circuit to improve compliance with the reciprocity theorem the signal generator comprises a characterization amplifier coupled to a respective one of the ultrasonic transducers set to transmitter mode in the same way as the measuring amplifier is coupled to a respective one of the ultrasonic transducers set to receiver mode. Preferably, a respective one of the ultrasonic transducers set to transmitter mode is coupled to the non-inverting input of a characterization operational amplifier of the characterization amplifier. Besides achieving better symmetry, the characterization amplifier also allows for determining characteristics of the transmitting transducer, for example in order to take account of transducer characteristics during the calculation of flow and accommodate to changing environmental parameters or slowly degrading transducers.

In an embodiment the signal generator and the receiver circuit is formed by a combined signal generator and receiver circuit and the ultrasonic transducers are connected through the switching unit to the same node in the combined signal generator and receiver circuit regardless if they are set to the receiver mode or the transmitter mode, so that that the first receiver impedance is equal to the first transmitter impedance.

As the transducers are thereby connected to the same, combined, circuit at the same point regardless if they are transmitting or receiving, the perceived impedance is equal in both modes, thereby improving compliance with the reciprocity theorem.

In an embodiment the combined signal generator and receiver circuit comprises a shared operational amplifier implementing both the receiving operational amplifier and the transmitting operational amplifier.

An advantageous feature of the embodiment with combined signal generator and receiver circuit is the reduction of the number of components, as the combined circuit roughly spoken only uses half of the components used by the full system with separate signal generator and receiver circuit. Besides the advantage of reducing the number of components, it also improves the symmetry of transmitting and receiving as perceived from the transducers, as the circuit in these two modes not only looks the same, they are in fact the same.

In an embodiment the ultrasonic transducers by means of the control circuit and the switching unit can further be set to an idle mode, involving the respective ultrasonic transducer being disconnected from both the signal generator and the receiver circuit.

An idle mode is particularly relevant in configurations where the receiving transducer should not disturb the circuits while the transmitting transducer is transmitting, and vice versa. Such configurations most prominently comprise the combined signal generator and receiver circuit, where the two transducers are connected to the same point and would therefore directly disturb the measurement if connected simultaneously.

In an embodiment, the receiver circuit comprising a receiving operational amplifier, wherein the receiver circuit being arranged so that a first receiver impedance between a receiving ultrasonic transducer and an output of the receiving operational amplifier is less than or equal to a second receiver impedance between the receiving ultrasonic transducer and an inverting input of said receiving operational amplifier.

The receiver circuit described here is advantageous for use in ultrasonic flow meters as it features a reversed operational amplifier, thereby enabling better symmetry with a corresponding signal generator, which in turn improves compliance with the reciprocity theorem, improving stability and accuracy of flow measurements.

All the various discussions, considerations and embodiments described above also applies to this receiver circuit, and the embodiments described below.

In an embodiment the receiver circuit comprises a measuring amplifier.

In an embodiment the measuring amplifier comprises a measuring operational amplifier different from the receiving operational amplifier.

In an embodiment the measuring amplifier is arranged to provide a measured ultrasonic signal at a measurement output of the measuring amplifier, preferably at the output of the measuring operational amplifier.

In an embodiment the measuring amplifier is arranged to measure a representation of an AC current drawn through at least one power supply terminal of the receiving operational amplifier.

In an embodiment the measuring amplifier is coupled to said power supply terminal through a measurement impedance, preferably at least one capacitor.

In an embodiment the at least one power supply terminal of the receiving operational amplifier is coupled to said power supply through a sense impedance.

In an embodiment said sense impedance is larger than 10% of said measurement impedance, preferably equal to or larger than said measurement impedance.

In an embodiment said sense impedance is a resistor, preferably less than 1 kOhm.

In an embodiment the measuring amplifier is implemented substantially as a transimpedance amplifier with a sense input connected to said power supply terminal.

In an embodiment the measuring amplifier is arranged to measure a representation of a voltage at the respective one of the ultrasonic transducers set to receiver mode.

In an embodiment a respective one of the ultrasonic transducers set to receiver mode is coupled to the non-inverting input of a measuring operational amplifier of the measuring amplifier, and preferably a power regulating impedance is provided between said respective one of the ultrasonic transducers and said output of said receiving operational amplifier.

In an embodiment, a combined signal generator and receiver circuit comprising a shared operational amplifier, wherein the combined signal generator and receiver circuit being arranged so that a first receiver impedance between a receiving ultrasonic transducer and an output of the shared operational amplifier is less than or equal to a second receiver impedance between the receiving ultrasonic transducer and an inverting input of said shared operational amplifier.

In an embodiment the combined signal generator and receiver circuit comprises a single node for connecting to ultrasonic transducers regardless if they are set to a receiver mode or a transmitter mode, so that that the first receiver impedance is equal to a first transmitter impedance between a transmitting ultrasonic transducer and said output of said shared operational amplifier.

The combined signal generator and receiver circuit described here is advantageous for use in ultrasonic flow meters as it features a shared operational amplifier, and preferably single point of connection in both transmitting and receiving modes, thereby improving compliance with the reciprocity theorem, improving stability and accuracy of flow measurements, and also allowing for reduced signal line impedance during transmission than previously enabled in combined transmitter/receiver circuits.

All the various discussions, considerations and embodiments described above which are applicable to combined circuits also apply to this combined signal generator and receiver circuit.

In an embodiment the receiving amplifier is an operational amplifier.

In an embodiment the operational amplifier has a first input, preferably a non-inverting input, connected to ground or to a reference potential, a second input, preferably an inverting input, and an output connected to the second input via a feedback connection, and wherein the output is further connected to the second transducer.

In an embodiment the means for measuring a power supply current to said receiving amplifier comprises a measuring operational amplifier.

In an embodiment the means for measuring a power supply current to said receiving amplifier is arranged to determine a received ultrasonic signal from the measured power supply current and provide the determined received ultrasonic signal at a measurement output of the means for measuring a power supply current.

In an embodiment the means for measuring a power supply current to said receiving amplifier is arranged to measure a representation of an AC current drawn through at least one power supply terminal of the receiving amplifier.

In an embodiment the means for measuring a power supply current to said receiving amplifier is coupled to said power supply terminal through a measurement impedance, preferably at least one capacitor.

In an embodiment the at least one power supply terminal of the receiving amplifier is coupled to a power supply through a sense impedance.

In an embodiment said sense impedance is larger than 10% of said measurement impedance, preferably equal to or larger than said measurement impedance.

In an embodiment said sense impedance is a resistor, preferably less than 1 kOhm.

In an embodiment the means for measuring a power supply current to said receiving amplifier is implemented substantially as a transimpedance amplifier with a sense input connected to said power supply terminal.

In an embodiment, the receiver circuit comprising an operational amplifier as a receiving amplifier, wherein the operational amplifier has a first input, preferably a non-inverting input, connected to ground or to a reference potential, a second input, preferably an inverting input, and an output connected to the second input via a feedback connection, and wherein the output is further connected to the receiving transducer.

All the various discussions, considerations and embodiments described above also applies to this flow meter.

In an embodiment, the ultrasonic flow meter comprising a transmitting and a receiving ultrasonic transducers, a receiver circuit for receiving an electrical reception signal from the receiving ultrasonic transducer and comprising and operational amplifier as a receiving amplifier, and a switching unit for switching the electrical reception signal between the transducers and the receiver circuit, wherein the operational amplifier has a first input, preferably a non-inverting input, connected to ground or to a reference potential, a second input, preferably an inverting input, and an output connected to the second input via a feedback connection, and wherein the output is further connected to the receiving transducer, and the operational amplifier is arranged to, upon operation of the switching unit, having its output connected to the transmitting transduce, and having its first input connected to a signal source.

All the various discussions, considerations and embodiments described above also applies to this flow meter.

## The drawings

Various embodiments of the invention will in the following be described with reference to the drawings where

figs. 1 - 4 illustrate prior art flow meters,

figs. 5 - 7 illustrate an embodiment of the invention,

figs. 8 - 10 illustrate a combined transmitter/ receiver embodiment of the invention,

fig. 11 illustrates an embodiment of the invention showing alternative locations of the power regulating impedances,

figs. 12 - 15 illustrate various embodiment of the invention with power supply terminal mounted measurement amplifier,

fig. 16 illustrates an embodiment of the invention showing the additional features of a characterization amplifier, and

figs. 17 - 18 illustrate various embodiment of the invention with an alternative measurement amplifier.

## Detailed description

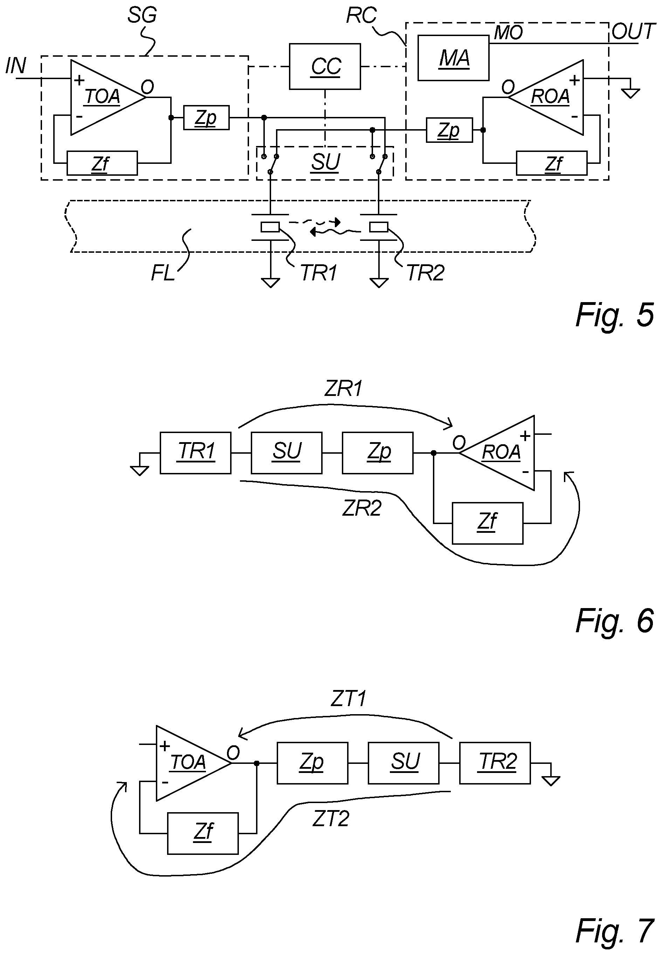

Fig. 5 is a block diagram of an ultrasonic flow meter according to an embodiment of the invention which may increase the stability and accuracy due to improved compliance with the reciprocity theorem and which may be implemented in small flow meters.

The ultrasonic flow meter comprises two ultrasonic transducers TR1, TR2 shown generally in connection with fluid FL in the block diagram drawing. The ultrasonic transducers TR1, TR2 may in practice and within the scope of the claims be arranged in any of the many ways proximate to the measured fluid FL as known by the person skilled in the art of ultrasonic flow meters in such a way that ultrasound emitted by one of the transducers TR2 can be received by the other transducer TR1 after having travelled through the fluid to be measured as shown by the solid waving arrow in the fluid, and vice versa as shown by the dashed waving arrow in the fluid. A few of the known transducer arrangements which are feasible with the present invention may include the transducers being located in the fluid and transmitting directly to each other along or against the flow direction, or being located in a pipe wall, flush or slanted, and transmitting to each other via a number of ultrasound reflectors located along the pipe, so as to cause a zigzagging ultrasound path between the transducers, at least partly along or against the flow direction. Other transducer arrangements may also be feasible with the present invention.

The ultrasonic transducers TR1, TR2 are both connectable to a signal generator SG and a receiver circuit RC via a switching unit SU. When a transducer is connected to the signal generator SG it is considered operating in a transmitter mode and is arranged to receive a transmission signal from the signal generator SG and produce ultrasound accordingly. Correspondingly, when a transducer is connected to the receiver circuit RC it is considered operating in a receiver mode and is arranged to receive the produced ultrasound via the fluid and generate a reception signal to be detected by the receiver circuit RC.

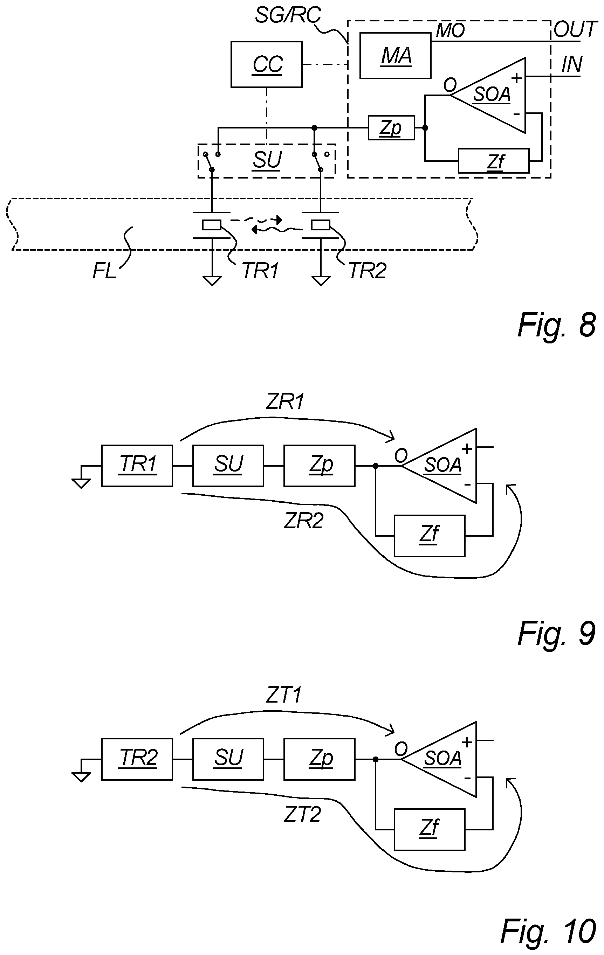

The switching unit SU is arranged to controllably couple the transducers to the signal generator SG, respectively the receiver circuit RC. The switching unit is controlled by a control circuit CC by means of a control connection e.g. as shown by the dash-dot line. The control circuit may thereby control which transducer TR1, TR2 is set to transmitter mode, and which is set to receiver mode. The switching unit SU is shown in general in the drawing, but may be implemented in any suitable way, for example as shown here, or as shown in any of Figs. 8, 11, 13, 15, 17 or 18, or as known by the person skilled in the art of ultrasonic flow meters with switchable transducers. In particular, the switching unit may comprise additional throw options to allow a transducer to be completely disconnected and thereby attain an idle mode, and/or additional switches to allow even more individualized control and configuration options. The switching unit SU may be implemented by any suitable switching means, including semiconductor-based switches, electromechanical switches, etc.

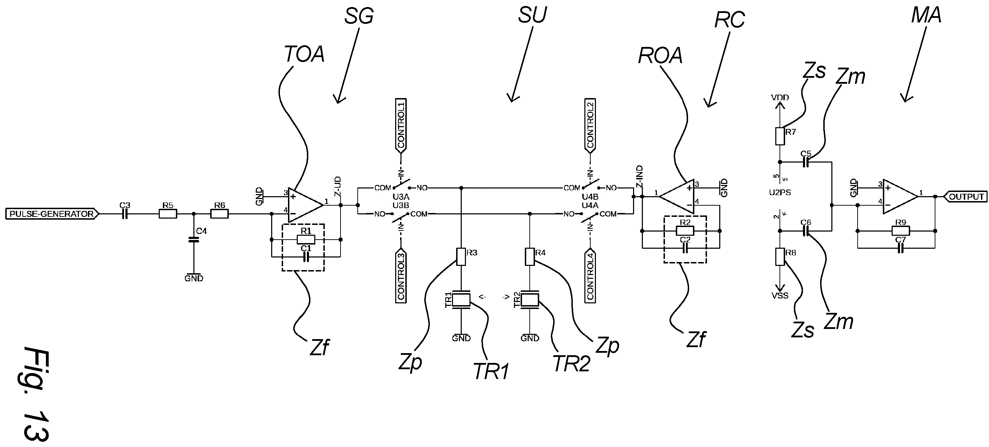

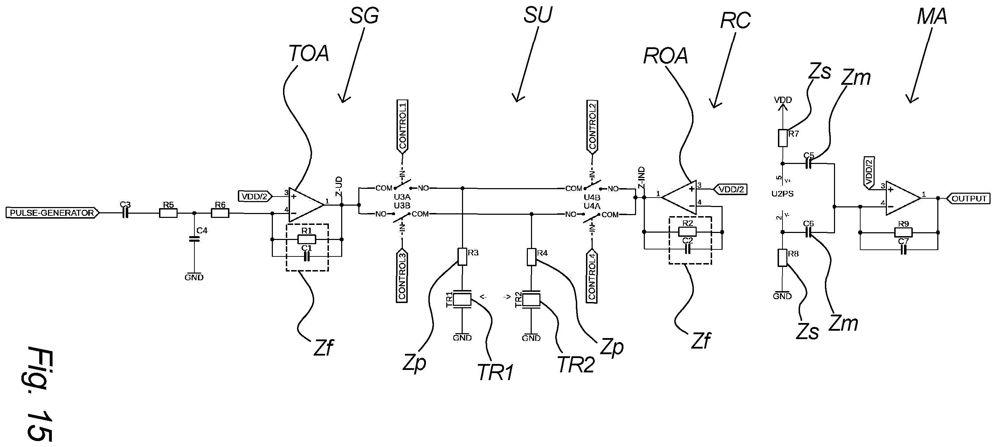

The ultrasonic flow meter comprises a signal generator SG having a transmission signal control input IN and being arranged to generate a transmission signal for the ultrasonic transducers set to transmitter mode. The signal generator SG comprises a transmitting operational amplifier TOA which is arranged with a feedback impedance Zf between its output O and its inverting input -, and receives the transmission signal control input IN on its non-inverting input +. The illustration is a block diagram showing the principle signal generator amplifier, and further auxiliary components such as for example decoupling components may be suitable, as known by the person skilled in the art. The signal generator SG may in alternative embodiments be implemented with the non-inverting input + being connected to a reference voltage, e.g. ground, and receiving the transmission signal control input IN on its inverting input together with a feedback from its output O, as for example illustrated in Figs. 13 and 15.

The amplified transmitter signal is output to the currently selected transducer TR2 through a power regulating impedance Zp, arranged to limit current peaks that may occur at the beginning of a transmission where a capacitive effect of the ultrasonic transducer may be most prominent. The power regulating impedance Zp is preferably a simple resistor but may also be designed with frequency dependent properties in some embodiments.

The ultrasonic flow meter further comprises a receiver circuit RC which receives reception signals from the ultrasonic transducers set to receiver mode and generates a measured ultrasonic signal output OUT. The receiver circuit RC comprises a receiving operational amplifier ROA arranged with the same feedback impedance Zf as the signal generator SG between its output O and its inverting input -. The non-inverting input + is connected to ground. Correspondingly to the signal generator SG, the illustration is a block diagram showing the principle receiver circuit amplifier, and further auxiliary components such as for example decoupling components may be suitable, as known by the person skilled in the art. The reception signal is received from the currently selected transducer TR1 through a power regulating impedance Zp corresponding to the power regulating impedance Zp of the signal generator SG in order to achieve symmetry and thereby improved compliance with the reciprocity theorem. In some embodiments, the power regulating impedance Zp may further benefit to cause the potential at the node between the transducer TR1 and the power regulating impedance Zp to be different from the ground potential and thereby allow better measurement of the received signal by some embodiments of measurement amplifiers MA as described in more detail below.

The receiver circuit RC further comprises a measurement amplifier MA having a measurement output MO at which the measured ultrasonic signal output OUT is generated. The measurement amplifier MA may be implemented and connected in various ways as described in more detail below, which is therefore not illustrated in the block diagram of Fig. 5.

The control circuit CC may also preferably be arranged to control the signal generator SG and/or the receiver circuit RC as illustrated by dash-dot control signals in the drawing.

To comply as much as possible to the reciprocity theorem, the signal generator SG and the receiver circuit RC should look as equal as possible with respect to impedances when seen from the transducers. Therefore, a novel feature conceived by the inventors of the present invention is to have the receiving operational amplifier ROA reversed so that the reception signal is coupled to the output O of the operational amplifier, instead of to its input as for example shown in the prior art Fig. 1. By also using similar feedback impedances Zf and power regulating impedances Zp and any relevant auxiliary components, the signal generator SG and receiver circuit RC are made to appear substantially identical to the transducers from an impedance perspective.

Reversing the operational amplifier in this way is highly unconventional and not a standard option to the skilled person.

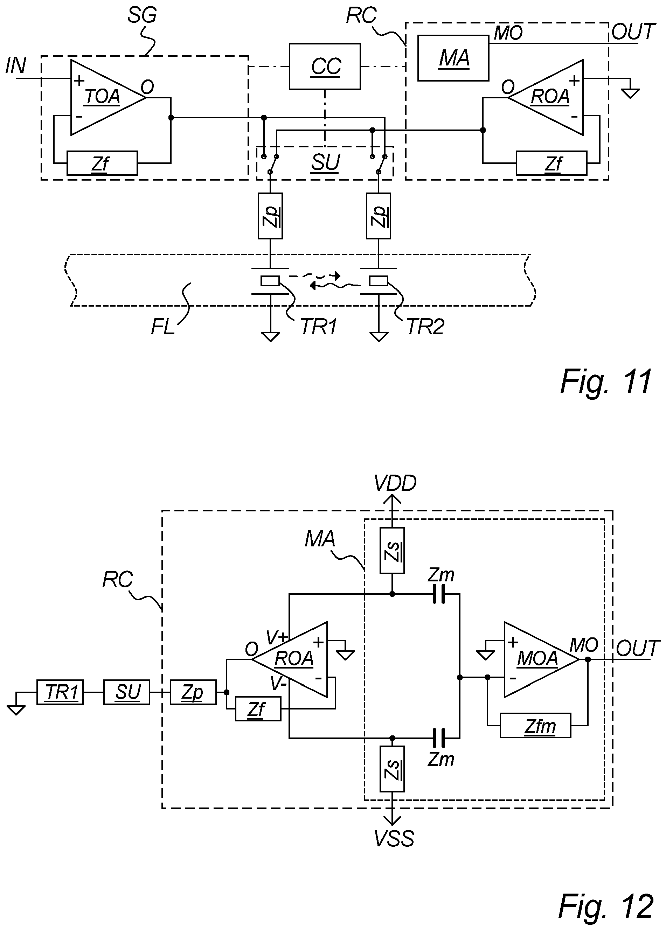

The power regulating impedance Zp may generally be selected based on the requirement to the signal generator and respective ultrasonic transducers as well-known by the person skilled in the art of ultrasonic flow meters, and then implementing the selected power regulating impedance Zp in both the signal generator SG and the receiver RC. As the power regulating impedance Zp is placed in series with the transducer, its actual magnitude of impedance directly affects the impedance perceived by the transducer. Any small difference between the power regulating impedances Zp of the signal generator SG and receiver circuit RC, respectively, will therefore cause a decrease in reciprocity. If it is difficult to obtain identical power regulating impedances, an alternative configuration of the power regulating impedances Zp is described below with reference to Fig. 11, which may be feasible in some embodiments. Further, some embodiment of the present invention may be designed to not experience the current peaks mentioned above, and may omit the power regulating impedance Zp altogether, thereby improving the reciprocity.

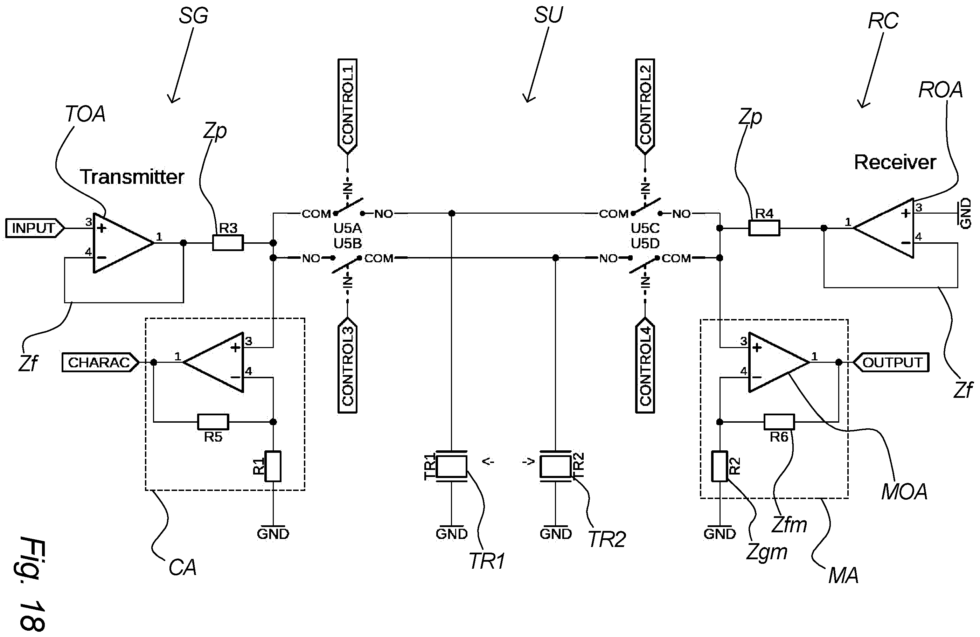

The feedback impedance Zf may in various embodiments be completely omitted as for example illustrated in Fig. 18. It can also be a simple resistor, or a frequency dependent impedance such as a resistor and a capacitor in parallel as for example illustrated in Figs. 13 - 15. Again, the design of the feedback loop should be balanced between the interests of the signal generator SG and the receiver circuit RC so that the impedances become equal. The feedback impedance may generally be selected based on the requirements to the signal generator as well-known by the person skilled in the art of ultrasonic flow meters, and then implementing the selected feedback impedance Zf in both the signal generator SG and the receiver circuit RC symmetrically.

Fig. 6 is a block diagram illustrating the impedances of the receiver circuit RC of the embodiment of Fig. 5 as seen from the transducers. In other words, Fig. 6 is a simplified version of Fig. 5, only showing the most prominent contributors to the receiver impedances. As illustrated in Fig. 6, a first receiver impedance ZR1 between a transducer TR1 in receiver mode and the output O of the receiving operational amplifier ROA consists of the impedances of the switching unit SU and the power regulating impedance Zp. A second receiver impedance ZR2 between the transducer TR1 in receiver mode and the inverting input - of the receiving operational amplifier ROA consists of the impedances of the switching unit SU, the power regulating impedance Zp and the feedback impedance Zf. In other words, the following relationships exist:

$$ZR1 \approx Z_{SU} + Zp$$

$$ZR2 \approx Z_{SU} + Zp + Zf$$

With the feedback impedance Zf being optional as described above, the two impedances ZR1 and ZR2 may in practice be equal in such an embodiment, but may also be different if a feedback impedance is applied. In any case, the following applies:

$$ZR1 \leq ZR2$$

This is an unconventional relationship for an operational amplifier, as the impedance to the output would normally be significantly higher than to the inverting input.

Fig. 7 is a block diagram illustrating the impedances of the signal generator SG of the embodiment of Fig. 5 as seen from the transducers. In other words, Fig. 7 is a simplified version of Fig. 5, only showing the most prominent contributors to the transmitter impedances. As illustrated in Fig. 7, a first transmitter impedance ZT1 between a transducer TR2 in transmitter mode and the output O of the transmitting operational amplifier TOA consists of the impedances of the switching unit SU and the power regulating impedance Zp. A second transmitter impedance ZT2 between the transducer TR2 in transmitter mode and the inverting input - of the transmitting operational amplifier TOA consists of the impedances of the switching unit SU, the power regulating impedance Zp and the feedback impedance Zf. In other words, the following relationships exists:

$$ZT1 \approx Z_{SU} + Zp$$

$$ZT2 \approx Z_{SU} + Zp + Zf$$

With the feedback impedance Zf being optional as described above, the two impedances ZT1 and ZT2 may in practice be equal in such an embodiment, but may also be different if a feedback impedance is applied. In any case, the following applies:

$$ZT1 \leq ZT2$$

Comparing Fig. 6 with Fig. 7 clearly shows that the impedances as seen from the transducers corresponds between the receiver circuit RC of Fig. 6 and the signal generator SG of Fig. 7. Moreover, the above relationships also show identical impedances:

$$ZR1 \approx ZT1$$

$$ZR2 \approx ZT2$$

Thereby a high compliance with the reciprocity theorem is shown, meaning that the embodiment of Fig. 5 has improved accuracy and stability over less complying solutions. Improved accuracy is achieved because the same impedances are perceived for transmissions in both directions, i.e. when the transducers switch modes between transmitting and receiving. Improved stability is achieved because temperature changes and other environmental fluctuations or degradation of transducers over time have the same impact on both the transmitting and the receiving circuit, again regardless of which transducer is currently in which mode.

Another benefit of the general embodiment of Fig. 5 is that the receiver circuit RC can start receiving even while the signal generator SG is transmitting. This allows for reducing the distance between the two transducers, thereby enabling implementation in small flow meters. The distance can be reduced with less or no consideration of the otherwise required balancing of signal duration and propagation time.

Fig. 8 is a block diagram of a combined transmitter/receiver ultrasonic flow meter according to an embodiment of the invention which may increase the stability and accuracy due to improved compliance with the reciprocity theorem, as well as reduce the transmitter impedance for increased transmission power efficiency.

The embodiment of Fig. 8 is in many ways similar to the embodiment of Fig. 5, and will therefore be described relative thereto. Instead of providing both a signal generator SG and a receiver circuit RC, the combined embodiment comprises a combined signal generator and receiver circuit SG/RC, comprising a shared operational amplifier SOA. The control circuit CC has a control connection to the combined signal generator and receiver circuit SG/RC to control when it behaves as a signal generator and when it behaves as a receiver circuit. The control circuit CC also controls the switching unit SU in order to control the modes of the transducers. As the combined signal generator and receiver circuit SG/RC can only transmit or receive at a time, also only one of the transducers should preferably be connected to the combined signal generator and receiver circuit SG/RC at a time. The switching unit of the embodiment of Fig. 8 therefore enables an idle mode for the currently unused transducer.

As known by the skilled person in ultrasonic flow meters with combined transmitter and receiver, to perform a measurement, the control circuit CC may first set, e.g., the second transducer TR2 in transmitter mode and the other in idle mode, and get the combined signal generator and receiver circuit SG/RC to transmit a signal through the transmitter mode transducer. After finishing the transmission, the control circuit causes the switching unit SU to set the transmitting transducer in idle mode and the other, e.g. the first transducer TR1, in receiver mode, and get the combined signal generator and receiver circuit SG/RC to measure the received ultrasound.

However, with the present embodiment of the present invention, the arrangement of the shared operational amplifier SOA is different than in prior art combined transmitter/receiver flow meters. The shared operational amplifier SOA of the present embodiment is so-to-say reversed so that the transducer is coupled to the output O of the shared operational amplifier SOA, through a power regulating impedance Zp as described above. The shared operational amplifier SOA may also have a feedback impedance Zf corresponding to the description of Fig. 5. Further, a measuring amplifier MA is included to provide a measured ultrasonic signal output OUT at a measurement output MO.

Figs. 9-10 illustrate that the receiver impedances ZR1, ZR2, respectively the transmitter impedances ZT1, ZT2, are equivalent to the situation of the embodiment of Fig. 5 as described in more detail above. Hence, the following relationships also apply to the embodiment with combined signal generator and receiver circuit SG/RC of Fig. 8:

$$ZR1 \approx Z_{SU} + Zp \quad \text{and} \quad ZR2 \approx Z_{SU} + Zp + Zf \quad => \quad ZR1 \leq ZR2$$

$$ZT1 \approx Z_{SU} + Zp \quad \text{and} \quad ZT2 \approx Z_{SU} + Zp + Zf \quad => \quad ZT1 \leq ZT2$$

and

$$ZR1 \approx ZT1, \qquad ZR2 \approx ZT2$$

In other words, the same improvement regarding compliance with the reciprocity theorem is achieved as described above. Further, comparing with the prior art combined transmitter/receiver solutions, for example in Fig. 3, it can be seen that the transmitter impedance can be reduced by the reversed shared operational amplifier SOA arrangement of the present invention, as the transmission signal of the present invention is only subject to the power regulating impedance Zp, and - contrary to the Fig. 2 embodiment - not to the feedback impedance Zf. Thereby the power efficiency during transmission is improved, and larger signals may be received during receiver mode.

The considerations about dimensioning the components and other implementation aspects described above, and various alternatives described, with Figs. 5-7 apply equally to the embodiment of Figs. 8-10.

Fig. 11 is a block diagram showing an alternative of the embodiment of Fig. 5, the only difference being the power regulating impedances Zp being moved from the output O of the operational amplifiers TOA, ROA, to the node between the transducer and the switching unit SU. The embodiment of Fig. 11 causes each power regulating impedance Zp to be tied to the same transducer TR1, TR2, and thereby alternating operational amplifiers TOA, ROA, depending on the mode given to the transducer. This is contrary to the embodiments of for example Figs. 5 and 8, where each power regulating impedance Zp is tied to the same operational amplifier TOA, ROA, and thereby alternating transducer TR1, TR2, depending on their mode. If identical resistors are difficult to obtain, the embodiment of Fig. 11 where the power regulating impedances Zp are implemented on the transducer-side of the switching unit SU provides a better symmetry and thereby improved compliance with the reciprocity theorem.

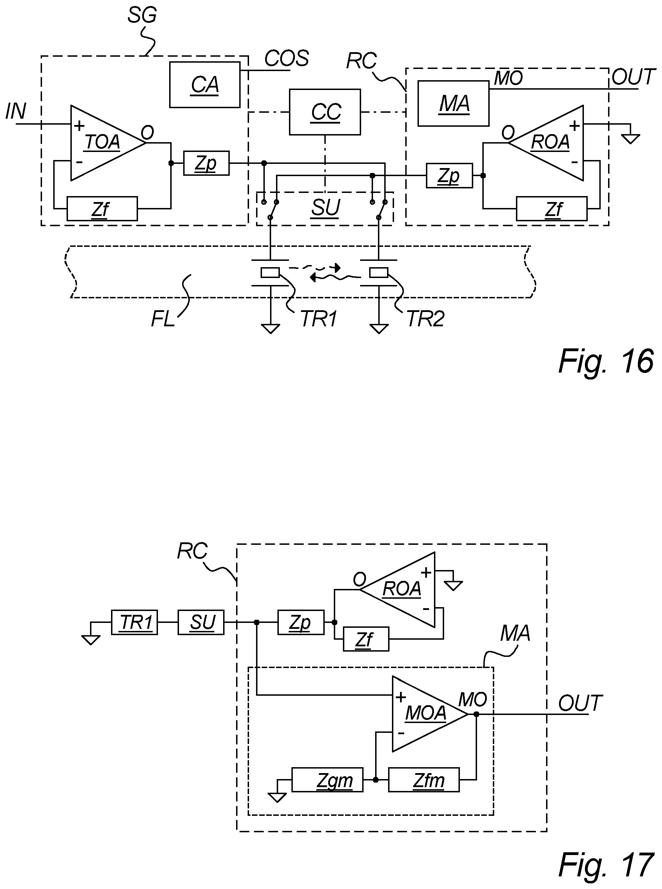

Locating the power regulating impedances Zp between the transducers and the ground is also a feasible embodiment of the invention, and provides the same advantage as described for the Fig. 11-embodiment. All the various alternatives and considerations described above with reference to the Fig. 5 embodiment, or the combined signal generator and receiver circuit embodiment of Fig. 8, are also applicable to the embodiment of Fig. 11, although for a combined signal generator and receiver circuit embodiment, the location of the power regulating impedance Zp at the shared operational amplifier SOA as shown in Fig. 8 is preferable as it only requires a single power regulating impedance Zp. The improvement in some implementations provided by the configuration of Fig. 11, may also be achieved by similar rearrangement of other embodiments within the scope of the claims, for example all the embodiments described in the present application, for example Fig. 12 and 16.

Fig. 12 is a block diagram of an embodiment of a measuring amplifier MA advantageously applicable to the receiver circuit RC of any of the above-described embodiments of the present invention. The receiving operational amplifier ROA, which could also be the shared operational amplifier SOA, is coupled in reverse as described above with an optional feedback impedance Zf, and the selected ultrasonic transducer TR1 connected to the output O of the receiving operational amplifier ROA through the switching unit SU and the power regulating impedance Zp.

In the advantageous embodiment of Fig. 12, the measuring amplifier MA is arranged as a power supply for the receiving operational amplifier ROA, which thereby also allows the measuring amplifier MA to sense the current consumption of the receiving operational amplifier ROA. The positive and negative power supply terminals V+, V- of the receiving operational amplifier ROA is thus connected to the positive and negative power supply rails VDD, VSS, respectively, through sense impedances Zs.

A measuring operational amplifier MOA is provided in the measuring amplifier MA, with its output being the measurement output MO for providing the measured ultrasonic signal output OUT. The non-inverting input of the measuring operational amplifier MOA is connected to ground or a reference voltage. The measuring operational amplifier MOA has a measurement feedback impedance Zfm connected between the measurement output MO and its inverting input. The inverting input of the measuring operational amplifier MOA is further connected to the positive and negative power supply terminals V+, V- of the receiving operational amplifier ROA, however through measurement impedances Zm, preferably capacitors or other DC rejecting or reducing impedances.

With the embodiment of Fig. 12 as described above, the combined task of the sense impedances Zs and the DC rejecting measurement impedances Zm is to cause the DC current consumption of the receiving operational amplifier ROA to be drawn from the power supply rails VDD, VSS through the sense impedances Zs, but fluctuations in the current consumption, i.e. AC components, should at least partly be drawn from the measuring operational amplifier MOA through the measurement impedances Zm to allow detection thereof.

The measurement impedances Zm should therefore preferably be significantly small for the relevant AC frequency compared to the sense impedances Zs to cause a measurable amplitude of the AC component be drawn from the measurement operational amplifier instead of through the sense impedances Zs. For example, the sense impedance Zs should not be less than 10% of the measurement impedance Zm at the signal frequency, and should preferably even be approximately equal to or larger than the measurement impedance Zm at the signal frequency. On the other hand, the sense impedances Zs should also not be so large, that too much power is wasted or not enough DC current is available for operating the receiving operational amplifier ROA. For example, the sense impedance Zs should preferably be no more than 1 kOhm, thereby causing the magnitude of the measurement impedance Zm, preferably a capacitor, at the signal frequency, to also preferably be no more than 1 kOhm, but possibly up to around 10 kOhm. In an embodiment, the sense impedances are implemented with coils or ferrite cores to reject AC currents, and thereby allow for a bigger part of the AC component of the signal to be detectable at the measuring operational amplifier MOA.

The receiving operational amplifier ROA will by the present embodiment draw a fluctuating supply current when an ultrasound signal is received by the receiver mode transducer, for example the first ultrasonic transducer TR1 in this example. The AC current generated by a receiving ultrasonic transducer is running to and from the receiving operational amplifier ROA, thereby also noticeable at the power supply terminals of the receiving operational amplifier ROA. In other words, the AC part of the current consumption of the receiving operational amplifier ROA, or of the shared operational amplifier SOA during receiving, is representative of the ultrasound signal received at the transducer in receiver mode. The measurement output of the measurement operational amplifier MOA becomes a representation of the AC current drawn through the power supply terminals of the receiving operational amplifier ROA, and thereby indirectly also a representation of the received ultrasound signal.

The advantageous embodiment of Fig. 12 thereby provides a receiver circuit RC which enables compliance with the reciprocity theorem by mirroring a possible signal generator SG, further provides for a very low impedance, and yet provides a surprisingly non-disturbing and yet feasible way of measuring the received ultrasound signals by the power supply terminal coupled measuring amplifier MA of the present embodiment.

As described above with the embodiment of Fig. 5, additional auxiliary components, e.g. decoupling components, may be added for optimization of the circuit. Further, all the various alternatives and considerations described above with reference to the Fig. 5 embodiment, or the combined signal generator and receiver circuit embodiment of Fig. 8, and the alternative embodiment of Fig. 11, are also applicable to the embodiment of Fig. 12. When implementing the measurement amplifier MA of the Fig. 12-embodiment in a combined signal generator and receiver circuit embodiment such as the one discussed with reference to Fig. 8, the measurement amplifier MA should just be arranged as power supply for the shared operational amplifier SOA, but otherwise be as described above for the receiving operational amplifier ROA.

Fig. 13 is a more detailed implementation of an embodiment of the invention according to the principles described above with reference to primarily Figs. 5, 11 and 12. The embodiment of Fig. 13 comprises a signal generator SG with a transmitting operational amplifier TOA having a feedback impedance Zf, in this example consisting of a resistor and a capacitor. Fig. 13 also illustrates a system of auxiliary components implemented at the input of the transmitting operational amplifier TOA and consisting of series-coupled capacitors and resistors, and a decoupling capacitor to ground, together also forming a filter to remove undesired frequency components from the transmission signal. Comparing with the embodiment of for example Fig. 5, it is seen that the transmission signal control input is receiving on the non-inverting input of the transmission operational amplifier TOA in the embodiment of Fig. 5, while it is received in the inverting input in the embodiment of Fig. 13. Both variants are applicable in all the embodiments described herein.

A switching unit SU is also provided, comprising four switches arranged to enable setting the transducers individually into transmitter mode, receiver mode or idle mode. The switching unit SU is controlled by a control circuit CC (not shown) as described above.

The ultrasonic transducers TR1, TR2 are coupled to the switching unit SU through the power regulating impedances Zp in a similar way as described above with reference to Fig. 11 to achieve the benefits thereof described above.

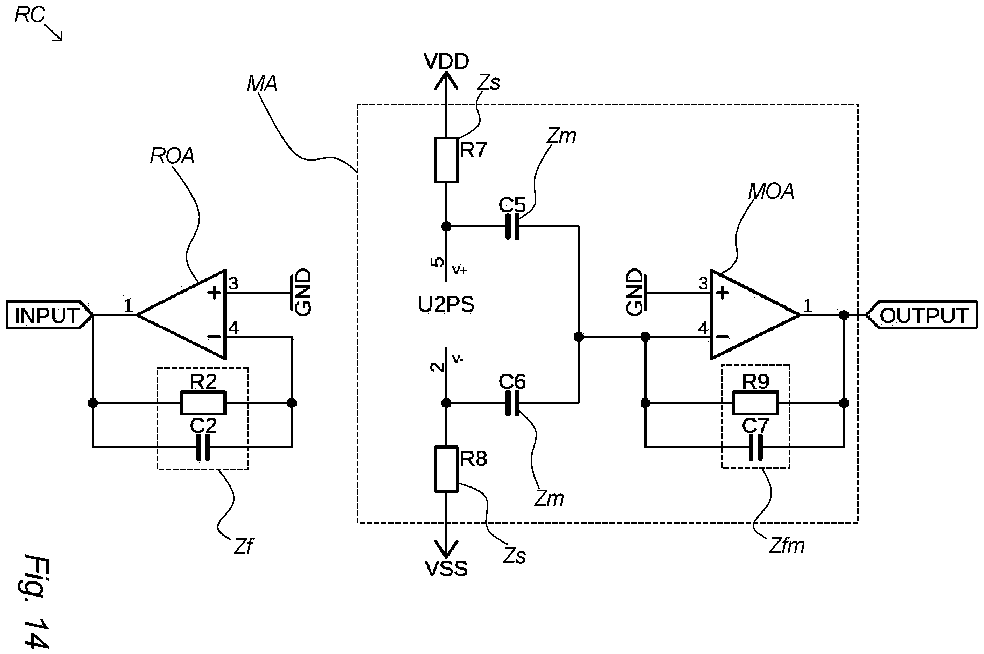

The receiver circuit RC with measurement amplifier MA is generally implemented in correspondence with the description related to Fig. 12. An enlarged view of this part of Fig. 13, is provided as separate Fig. 14. The node labeled 'INPUT' at Fig. 14 is connected to the receiver circuit side of the switching unit SU in Fig. 13. The receiving operational amplifier ROA is arranged as a mirror of the transmitting operational amplifier TOA described above, i.e. with corresponding resistor and capacitor forming the feedback impedance Zf.

A measurement amplifier MA similar to the one described above with reference to Fig. 12 is provided and coupled to the positive and negative power supply terminals V+, V-, respectively, of the receiving operational amplifier ROA. The measurement amplifier MA comprises sense impedances Zs and measurement impedances Zm in correspondence with the considerations given above with reference to Fig. 12. Correspondingly is also implemented a measuring operational amplifier MOA with a measurement feedback impedance Zfm, in this example consisting of a resistor and a capacitor. At the output terminal of the measuring operational amplifier MOA is provided the measured ultrasonic signal output OUT.

Fig. 15 illustrates an embodiment implemented for single supply instead of double supply as used in the Figs. 13-14 embodiment. In a single supply system, the negative power supply terminal V- of the receiving operational amplifier ROA is connected to ground instead of to the a negative power supply rails VSS, while the positive power supply terminal V+ is still connected to the positive power supply rail VDD. This also applies to the other transmitting operational amplifier TOA and measuring operational amplifier MOA, where the power supplies have not been drawn, to avoid too complex drawings. This difference from the embodiment described with reference to Figs. 13-14 is that the reference signals to the non-inverting inputs of all three operational amplifiers TOA, ROA, MOA, should therefore be the half of the positive supply rail voltage VDD, instead of ground. Otherwise, the above description related to any of Figs. 5-14 is also applicable to the embodiment of Fig. 15, and this way of enabling a single supply solution may be incorporated into any of the other embodiments discussed herein.

Fig. 16 illustrates a block diagram of an embodiment of the present invention. The embodiment is very similar to the embodiment described with reference to Fig. 5, however with the additional of a characterization amplifier CA. This advantageous addition is also applicable to any of the other embodiments described herein.

The characterization amplifier CA implemented in the signal generator SG is providing a characterization output signal COS, and is preferably implemented to mirror the measurement amplifier MA of the receiver circuit RC for improved compliance to the reciprocity theorem, in embodiments where the measurement amplifier MA may cause a detectable change in receiver impedances ZR1, ZR2. The characterization amplifier CA also has an advantageous usage, as it can be used to detect characteristics of the ultrasonic transducer acting in transmitter mode, and thereby allow the flow meter to take account of transducer characteristics during the calculation of flow and accommodate to changing environmental parameters or slowly degrading transducers.

Fig. 17 is a block diagram of an alternative embodiment of a measurement amplifier MA of the receiver circuit RC according to an embodiment of the invention. In this embodiment, the measurement amplifier MA also preferably comprises a measuring operational amplifier MOA having a measurement output MO at which the measured ultrasonic signal output OUT is delivered. The measurement amplifier MA is in this example implemented with a measurement feedback impedance Zfm between the output and inverting input, and a measurement gain impedance Zgm between the inverting input and ground. The non-inverting input of the measurement operational amplifier MOA is connected to a node between the transducer TR1, TR2, and the power regulating impedance Zp, in this example between the switching unit SU and power regulating impedance Zp. The measurement amplifier MA connected to the transducer in this way, may also be implemented by different other measurement signal amplifier technologies. However, to achieve improved compliance of the reciprocity theorem, the measurement amplifier MA connected in this way should be mirrored in the signal generator SG, for example as described in principle with reference to Fig. 16.

Fig. 18 is a more detailed implementation of an embodiment of the invention according to the measurement amplifier principles described above with reference to primarily Figs. 16 - 17. The receiver circuit RC is slightly different from the embodiment of Fig. 16 by illustrating the possibility of omitting the feedback impedance Zf of the receiver operational amplifier ROA. As mentioned above, an implementation of the measurement amplifier MA which connects more impedance disturbingly than described for the embodiments of Figs. 5-15, should preferably be mirrored in the signal generator SG. Therefore, the signal generator SG of the embodiment of Fig. 18 also comprises a characterization amplifier CA implemented in accordance with the measurement amplifier and with the benefits described above.

Among other, the reversed operational amplifier setup causes the output O of the receiving operational amplifier ROA to approach ground potential. Therefore, the power regulating impedance Zp should be dimensioned sufficiently large to cause a measurable voltage to be generated at the node between the transducer TR1, TR2, and the power regulating impedance Zp, when receiving ultrasound, but on the other hand sufficiently small to not take away too much of the transmitting power in the signal generator SG.

The measurement amplifier solution of Figs. 17-18 may also be used with a solution where the power regulating impedances Zp are mounted at the transducers as described above with reference to Fig. 11. The measurement amplifier MA should, however, still be connected to the node between the transducer and the power regulating impedance Zp. As this node in an embodiment like Fig. 11 where the power regulating impedances Zp are between the switching unit SU and the transducer, an embodiment thereof requires additional switches to switch the measuring amplifier between the transducers when their modes are switched.

List of reference signs:

CA          Characterization amplifier
CC          Control circuit

| COA | Characterization operational amplifier |
|---|---|
| COS | Characterization output signal |
| FL | Fluid |
| IN | Transmission signal control input |
| MA | Measuring amplifier |
| MO | Measurement output |
| MOA | Measuring operational amplifier |
| OUT | Measured ultrasonic signal output |
| RA | Receiving amplifier |
| RC | Receiver circuit |
| ROA | Receiving operational amplifier |
| SG | Signal generator |
| SG/RC | Combined signal generator and receiver circuit |
| SOA | Shared operations amplifier |
| SU | Switching unit |
| TOA | Transmitting operational amplifier |
| TR1, TR2 | Ultrasonic transducers |
| Zf | Feedback impedance |
| Zfm | Measurement feedback impedance |
| Zgm | Measurement gain impedance |
| Zm | Measurement impedance |
| Zp | Power regulating impedance |
| ZR1, ZR2 | First and second receiver impedances |
| Zs | Sense impedance |
| ZT1, ZT2 | First and second transmitter impedances |
| +, - | Non-inverting and inverting input of an operational amplifier |
| O | Output of an operational amplifier |
| V+, V- | Positive and negative power supply terminals of an operational amplifier |
| VDD, VSS | Positive and negative power supply rail |

**Claims**

1. An ultrasonic flow meter comprising a first and a second ultrasonic transducers (TR1, TR2), a signal generator (SG) for generating an electrical transmission signal to the first transducer (TR1), and a receiver circuit (RC) for receiving electrical reception signals from the second transducer (TR2), the receiver circuit (RC) comprising a receiving amplifier (RA; ROA; SOA),
**characterized in that**:
the receiver circuit (RC) comprising means for measuring a power supply current to said receiving amplifier (RA; ROA; SOA).

2. The ultrasonic flow meter of claim 1, wherein the means for measuring a power supply current to said receiving amplifier (RA; ROA; SOA) comprises a measuring amplifier (MA) comprising a measuring operational amplifier (MOA).

3. The ultrasonic flow meter of claim 1 or 2, wherein the means for measuring a power supply current to said receiving amplifier (RA; ROA; SOA) is arranged to determine a received ultrasonic signal from the measured power supply current and provide the determined received ultrasonic signal at a measurement output (MO) of the means for measuring a power supply current.

4. The ultrasonic flow meter of any of claims 1-3, wherein the means for measuring a power supply current to said receiving amplifier (RA; ROA; SOA) is arranged to measure a representation of an AC current drawn through at least one power supply terminal (V+, V-) of the receiving amplifier (RA).

5. The ultrasonic flow meter of claim 4, wherein the means for measuring a power supply current to said receiving amplifier (RA; ROA; SOA) is coupled to said power supply terminal (V+, V-) through a measurement impedance (Zm), preferably at least one capacitor.

6. The ultrasonic flow meter of claim 4 or 5, wherein the at least one power supply terminal (V+, V-) of the receiving amplifier (RA; ROA; SOA) is coupled to a power supply (VDD, VSS; VDD, GND) through a sense impedance (Zs).

7. The ultrasonic flow meter of claim 6, wherein said sense impedance (Zs) is larger than 10% of said measurement impedance (Zm), preferably equal to or larger than said measurement impedance (Zm).

8. The ultrasonic flow meter of claim 6 or 7, wherein said sense impedance (Zs) is a resistor, preferably less than 1 kOhm.

9. The ultrasonic flow meter of any of claims 1-8, wherein the means for measuring a power supply current to said receiving amplifier (RA; ROA; SOA) is implemented substantially as a transimpedance amplifier with a sense input connected to said power supply terminal (V+, V-).

10. The ultrasonic flow meter of any of claims 1-9, wherein the receiving amplifier (RA) is an operational amplifier (ROA; SOA) different from said measuring operational amplifier (MOA).

11. The ultrasonic flow meter of claim 10, wherein the operational amplifier (ROA; SOA) has a first input, preferably a non-inverting input (+), connected to ground or to a reference potential, a second input, preferably an inverting input (-), and an output (O) connected to the second input (-) via a feedback connection, and wherein the output (O) is further connected to the second transducer (TR2).

12. The ultrasonic flow meter of claim 10 or 11, wherein a first receiver impedance (ZR1) between the receiving ultrasonic transducer (TR2) and an output of the receiving operational amplifier (ROA; SOA) is less than or equal to a second receiver impedance (ZR2) between the receiving ultrasonic transducer (TR2) and an inverting input of said receiving operational amplifier (ROA; SOA).

13. The ultrasonic flow meter of any of claims 1-12, wherein the signal generator (SG) and receiver circuit (RC) are formed by a combined signal generator and receiver circuit (SG/RC), the combined signal generator and receiver circuit (SG/RC) comprising a shared operational amplifier (SOA) as said receiving amplifier (RA).

**Patentansprüche**

1. Ultraschalldurchflussmesser, umfassend einen ersten und einen zweiten Ultraschallwandler (TR1, TR2), einen Signalgenerator (SG) zum Generieren eines elektrischen Übertragungssignals an den ersten Wandler (TR1), und eine Empfängerschaltung (RC) zum Empfangen elektrischer Empfangssignale von dem zweiten Wandler (TR2), die Empfängerschaltung (RC) umfassend einen Empfangsverstärker (RA; ROA; SOA),
**dadurch gekennzeichnet, dass:**
die Empfängerschaltung (RC) ein Mittel zum Messen eines Leistungsversorgungsstroms zu dem Empfangsverstärker (RA; ROA; SOA) umfasst.

2. Ultraschalldurchflussmesser nach Anspruch 1, wobei das Mittel zum Messen eines Leistungsversorgungsstroms zu dem Empfangsverstärker (RA; ROA; SOA) einen Messverstärker (MA), umfassend einen Messoperationsverstärker (MOA), umfasst.

3. Ultraschalldurchflussmesser nach Anspruch 1 oder 2, wobei das Mittel zum Messen eines Leistungsversorgungsstroms zu dem Empfangsverstärker (RA; ROA; SOA) angeordnet ist, um ein empfangenes Ultraschallsignal von dem gemessenen Leistungsversorgungsstrom zu bestimmen und das bestimmte empfangene Ultraschallsignal an einem Messausgang (MO) des Mittels zum Messen eines Leistungsversorgungsstroms bereitzustellen.

4. Ultraschalldurchflussmesser nach einem der Ansprüche 1 bis 3, wobei das Mittel zum Messen eines Leistungsversorgungsstroms zu dem Empfangsverstärker (RA; ROA; SOA) angeordnet ist, um eine Darstellung eines Wechselstroms, der durch mindestens einen Leistungsversorgungsanschluss (V+, V-) des Empfangsverstärkers (RA) gezogen wird, zu messen.

5. Ultraschalldurchflussmesser nach Anspruch 4, wobei das Mittel zum Messen eines Leistungsversorgungsstroms zu dem Empfangsverstärker (RA; ROA; SOA) mit dem Leistungsversorgungsanschluss (V+, V-) durch eine Messimpedanz (Zm), vorzugsweise mindestens einen Kondensator, gekoppelt ist.

6. Ultraschalldurchflussmesser nach Anspruch 4 oder 5, wobei der mindestens eine Leistungsversorgungsanschluss (V+, V-) des Empfangsverstärkers (RA; ROA; SOA) mit einer Leistungsversorgung (VDD, VSS; VDD, GND) durch eine Abtastimpedanz (Zs) gekoppelt ist.

7. Ultraschalldurchflussmesser nach Anspruch 6, wobei die Abtastimpedanz (Zs) größer als 10 % der Messimpedanz (Zm), vorzugsweise gleich oder größer als die Messimpedanz (Zm), ist.

8. Ultraschalldurchflussmesser nach Anspruch 6 oder 7, wobei die Abtastimpedanz (Zs) ein Widerstand, vorzugsweise kleiner als 1 kOhm, ist.

9. Ultraschalldurchflussmesser nach einem der Ansprüche 1 bis 8, wobei das Mittel zum Messen eines Leistungsversorgungsstroms zu dem Empfangsverstärker (RA; ROA; SOA) im Wesentlichen als ein Transimpedanzverstärker mit einem Abtasteingang, der mit dem Leistungsversorgungsanschluss (V+, V-) verbunden ist, implementiert ist.

10. Ultraschalldurchflussmesser nach einem der Ansprüche 1 bis 9, wobei der Empfangsverstärker (RA) ein Operationsverstärker (ROA; SOA), der sich von dem Messoperationsverstärker (MOA) unterscheidet, ist.

11. Ultraschalldurchflussmesser nach Anspruch 10, wobei der Operationsverstärker (ROA; SOA) einen ersten Eingang, vorzugsweise einen nicht invertierenden Eingang (+), der mit Masse oder mit einem Referenzpotential verbunden ist, einen zweiten Eingang, vorzugsweise einen invertierenden Eingang (-), und einen Ausgang (O), der über eine Rückkopplungsverbindung mit dem zweiten Eingang (-) verbunden ist, aufweist und wobei der Ausgang (O) ferner mit dem zweiten Wandler (TR2) verbunden ist.

12. Ultraschalldurchflussmesser nach Anspruch 10 oder 11, wobei eine erste Empfängerimpedanz (ZR1) zwischen dem Empfangsultraschallwandler (TR2) und einem Ausgang des Empfangsoperationsverstärkers (ROA; SOA) kleiner als oder gleich einer zweiten Empfängerimpedanz (ZR2) zwischen dem Empfangsultraschallwandler (TR2) und einem invertierenden Eingang des Empfangsoperationsverstärkers (ROA; SOA) ist.

13. Ultraschalldurchflussmesser nach einem der Ansprüche 1 bis 12, wobei der Signalgenerator (SG) und die Empfängerschaltung (RC) mittels einer kombinierten Signalgenerator- und Empfängerschaltung (SG/RC) ausgebildet sind, die kombinierte Signalgenerator- und Empfängerschaltung (SG/RC) umfassend einen gemeinsamen Operationsverstärker (SOA) als den Empfangsverstärker (RA).

## Revendications

1. Débitmètre à ultrasons comprenant un premier et un second transducteur à ultrasons (TR1, TR2), un générateur de signaux (SG) pour générer un signal de transmission électrique vers le premier transducteur (TR1), et un circuit récepteur (RC) pour recevoir des signaux de réception électriques provenant du second transducteur (TR2), le circuit récepteur (RC) comprenant un amplificateur de réception (RA ; ROA ; SOA),
   **caractérisé en ce que :**
   le circuit récepteur (RC) comprend un moyen de mesure d'un courant d'alimentation vers ledit amplificateur de réception (RA ; ROA ; SOA).

2. Débitmètre à ultrasons selon la revendication 1, dans lequel le moyen de mesure d'un courant d'alimentation vers ledit amplificateur de réception (RA ; ROA ; SOA) comprend un amplificateur de mesure (MA) comprenant un amplificateur opérationnel de mesure (MOA).

3. Débitmètre à ultrasons selon la revendication 1 ou 2, dans lequel le moyen de mesure d'un courant d'alimentation vers ledit amplificateur de réception (RA ; ROA ; SOA) est agencé pour déterminer un signal à ultrasons reçu à partir du courant d'alimentation mesuré et fournir le signal à ultrasons reçu déterminé au niveau d'une sortie de mesure (MO) du moyen de mesure d'un courant d'alimentation.

4. Débitmètre à ultrasons selon l'une quelconque des revendications 1 à 3, dans lequel le moyen de mesure d'un courant d'alimentation vers ledit amplificateur de réception (RA ; ROA ; SOA) est agencé pour mesurer une représentation d'un courant alternatif consommé à travers au moins une borne d'alimentation (V+, V-) de l'amplificateur de réception (RA).

5. Débitmètre à ultrasons selon la revendication 4, dans lequel le moyen de mesure d'un courant d'alimentation vers ledit amplificateur de réception (RA ; ROA ; SOA) est couplé à ladite borne d'alimentation (V+, V-) par l'intermédiaire d'une impédance de mesure (Zm), de préférence au moins un condensateur.

6. Débitmètre à ultrasons selon la revendication 4 ou 5, dans lequel l'au moins une borne d'alimentation (V+, V-) de l'amplificateur de réception (RA ; ROA ; SOA) est couplée à une alimentation (VDD, VSS ; VDD, GND) par l'intermédiaire d'une impédance de détection (Zs).

7. Débitmètre à ultrasons selon la revendication 6, dans lequel ladite impédance de détection (Zs) est supérieure à 10 % de ladite impédance de mesure (Zm), de préférence égale ou supérieure à ladite impédance de mesure (Zm).

8. Débitmètre à ultrasons selon la revendication 6 ou 7, dans lequel ladite impédance de détection (Zs) est une résistance, de préférence inférieure à 1 kOhm.

9. Débitmètre à ultrasons selon l'une quelconque des revendications 1 à 8, dans lequel le moyen de mesure d'un courant d'alimentation vers ledit amplificateur de réception (RA ; ROA ; SOA) est mis en œuvre sensiblement sous la forme d'un amplificateur à transimpédance avec une entrée de détection connectée à ladite borne d'alimentation (V+, V-).

10. Débitmètre à ultrasons selon l'une quelconque des revendications 1 à 9, dans lequel l'amplificateur de réception (RA) est un amplificateur opérationnel (ROA ; SOA) différent dudit amplificateur opérationnel de mesure (MOA).

11. Débitmètre à ultrasons selon la revendication 10, dans lequel l'amplificateur opérationnel (ROA ; SOA) a une première entrée, de préférence une entrée non inverseuse (+), connectée à la terre ou à un potentiel de référence, une seconde entrée, de préférence une entrée inverseuse (-), et une sortie (O) connectée à la seconde entrée (-) par l'intermédiaire d'une connexion de rétroaction, et dans lequel la sortie (O) est en outre connectée au second transducteur (TR2).

12. Débitmètre à ultrasons selon la revendication 10 ou 11, dans lequel une première impédance de récepteur (ZR1) entre le transducteur à ultrasons de réception (TR2) et une sortie de l'amplificateur opérationnel de réception (ROA ; SOA) est inférieure ou égale à une seconde impédance de récepteur (ZR2) entre le transducteur à ultrasons de réception (TR2) et une entrée inverseuse dudit amplificateur opérationnel de réception (ROA ; SOA).

13. Débitmètre à ultrasons selon l'une quelconque des revendications 1 à 12, dans lequel le générateur de signaux (SG) et le circuit récepteur (RC) sont formés par un circuit combiné de générateur de signaux et de récepteur (SG/RC), le circuit combiné de générateur de signaux et de récepteur (SG/RC) comprenant un amplificateur opérationnel partagé (SOA) en tant que ledit amplificateur de réception (RA).

Fig. 1 (Prior art)

Fig. 2 (Prior art)

Fig. 3 (Prior art)

Fig. 4 (Prior art)

Fig. 5

Fig. 6

Fig. 7

Fig. 8

Fig. 9

Fig. 10

Fig. 11

Fig. 12

Fig. 13

Fig. 14

Fig. 15

*Fig. 16*

*Fig. 17*

Fig. 18

26

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2011134470 A2
- WO 03036240 A1
- EP 0846936 A1
- US 20180198414 A1